(19) Europäisches Patentamt
European Patent Office
Office européen des brevets

(11) EP 0 772 636 B1

(12) EUROPEAN PATENT SPECIFICATION

(45) Date of publication and mention
of the grant of the patent:
09.10.2002 Bulletin 2002/41

(51) Int Cl.⁷: $C08F\ 2/46$, C08F 299/08,
C08G 77/18, C08G 77/20,
B29C 35/08, C09D 4/00,
C08K 5/00, C08L 83/04

(21) Application number: 95926697.4

(22) Date of filing: 14.07.1995

(86) International application number:
PCT/US95/08874

(87) International publication number:
WO 96/002579 (01.02.1996 Gazette 1996/06)

(54) **RADIATION- AND/OR MOISTURE-CURABLE SILICONE COMPOSITIONS**

STRAHLUNGS- ODER FEUCHTIGKEITSHÄRTBARE SILICONZUSAMMENSETZUNGEN

COMPOSITIONS DE SILICONE DURCISSABLES PAR RAYONNEMENT ET/OU PAR HUMIDITE

(84) Designated Contracting States:
AT BE CH DE DK ES FR GB GR IE IT LI LU MC NL
PT SE

(30) Priority: 15.07.1994 US 276019
01.08.1994 US 284016

(43) Date of publication of application:
14.05.1997 Bulletin 1997/20

(73) Proprietor: LOCTITE CORPORATION
Hartford, Connecticut 06106 (US)

(72) Inventors:
• CHU, Hsien, Kun
Wethersfield, CT 06109 (US)
• CROSS, Robert, P.
Simsbury, CT 06070 (US)
• BENNINGTON, Lester, D.
East Hartford, CT 06118 (US)

(74) Representative: Marchant, James Ian
Elkington and Fife,
Prospect House,
8 Pembroke Road
Sevenoaks, Kent TN13 1XR (GB)

(56) References cited:
US-A- 4 528 081          US-A- 4 913 930
US-A- 4 952 342

EP 0 772 636 B1

## Description

### Field of the Invention

The present invention relates to radiation- and/or moisture-curable silicone compositions, and to a method of making and using same.

### Description of the Related Art

Silicone materials are widely used in industry as well as in consumer markets as sealants, adhesives, coatings, potting compounds, etc.

Such materials include the so-called room temperature vulcanizable (RTV) silicones which are curable at ambient (room temperature) conditions, in the presence of atmospheric moisture. Typically, RTV silicone materials are manufactured by endcapping $\alpha$, $\omega$-silanol terminated silicones with various crosslinkers such as alkoxysilanes, oximinosilanes, acetoxysilanes, aminosilanes, and other silanes with hydrolyzable groups attached to the silicon atom(s) thereof.

The resulting RTV silicone materials are stored in moisture impermeable containers. During application, the materials are extruded or otherwise applied and exposed to ambient conditions for curing. The moisture in the air then will hydrolyze the hydrolyzable groups (alkoxy, oximino, acetoxy, amino, etc.) on the silicon atom(s), to form silanol, either with or without the assistance of an added catalyst.

The resulting silanol can then further react with remaining unhydrolyzed groups in a condensation reaction, to form a siloxane linkage resulting in the cure of the silicone material.

The above-discussed reactions are illustrated below:

$$\sim\sim\sim\sim\sim Si\text{-}OH + R_nSiX_{4-n} \rightarrow \quad \sim\sim\sim\sim\sim Si\text{-}OSiR_nX_{3-n} + HX \tag{1}$$

where R=alkyl, aryl etc., X=OR, oximino, acetoxy, amino, amido etc., and n=0-2.

Depending on the X group, the above reaction may or may not require the assistance of a catalyst.

$$\sim\sim\sim\sim\sim Si\text{-}OSiR_nX_{3-n} + H_2O \quad \rightarrow \sim\sim\sim\sim\sim Si\text{-}OSiR_nX_{2-n}(OH) + HX \tag{2}$$

Again, depending on X group, catalyst(s) may or may not be present.

$$\sim\sim\sim\sim\sim Si\text{-}OSiR_nX_{2-n}(OH) + \quad \sim\sim\sim\sim\sim Si\text{-}OSiR_nX_{3-n} \quad \rightarrow$$

$$\sim\sim\sim\sim\sim Si\text{-}OSiR_nX_{2-n}\text{-}O\text{-}SiR_nX_{2-n}O\text{-}Si\sim\sim\sim\sim\sim + HX \tag{3}$$

Although the RTV materials are very reliable and possess superior properties in the aforementioned end use applications (sealants, adhesives, coatings, potting compounds, etc. ), the RTV materials often are very slow to cure. For example, a typical RTV silicone formulation often requires overnight curing before acceptable cure properties for the intended end use applications can be fully realized.

As a result, there exists a need to "fix," i.e., spatially immobilize, the applied RTV quickly, so that the applied material will not migrate from the locus of intended use, before a full cure of the RTV silicone is achieved. Such migration may be extremely deleterious. For example, if a sealant RTV formulation is applied to a joint to effect waterproof sealing thereof, migration such as sag or running of the sealant can take place (in the absence of adequate curing of the formulation). The migrated sealant formulation as a result may no longer overlie the joint to be sealed, so that the appertaining jointed structure may be rendered deficient or even useless for its intended purpose.

Considering other applications of silicone materials, silicone conformal coatings are widely used in the protection of delicate electronic components such as printed circuit boards as well as in abrasion resistant coatings for plastic lenses.

Typically, silicone conformal coatings are heat-cured using hydrosilylation reactions, or else are moisture-cured using conventional room temperature vulcanizing.

In the formulation and use of heat-cured silicone conformal coatings, silicone fluids with vinyl functional groups are reacted with silicone fluids containing silicon-hydrogen bonds in the presence of a transition metal catalyst, as for example chloroplatinic acid. The severity of the curing conditions required, along with the high cost of transition metal catalysts, has posed a serious obstacle to the use of such heat-cured silicone coatings.

The deficiencies of the moisture-cured conformal silicone coatings in respect of their slow rate of cure have already been discussed above. This slow cure puts a severe limitation on the manufacture of coated components, since full cure of the coated components is needed before the components can be used in the next step of the manufacturing process.

Because of the aforementioned limitations involved with heat or moisture curable silicone formulations, a third curing mode, ultraviolet light (uv) curing, has gained wide acceptance in recent years. The curing of radiation-curable silicones by uv or other actinic radiation is relatively fast and mild to the substrates. In situations where portions of the coated material are shaded during the uv cure, a secondary cure mode, usually moisture cure, can be further incorporated.

Typically, uv cure can be achieved by either a thiol-ene cure or by an acrylate cure. In the thiol-ene cure, a thiol functional silicone is reacted with a vinyl functional silicone. The cure is fast and the surface dry to the touch upon the completion of the cure. However, the finished coating resists heat aging poorly and the formulation tends to be storage unstable.

On the other hand, acrylate functional silicone is usually storage-stable and the cured coatings exhibit excellent high temperature resistance. However, the acrylate cure typically exhibits oxygen inhibition. That is, in the presence of atmospheric oxygen, the surface cure tends to be incomplete and the resulting cured coating tends to be tacky.

The art has proposed a wide variety of silicone compositions, but such compositions have failed to satisfactorily overcome the aforementioned deficiencies of conventional RTV silicones, heat-cure silicones, and radiation-curable silicones.

U.S. Patent No. 4,526,955 to Bennington et al. describes radiation-polymerizable compositions including organopolysiloxanes having -N-Si or N-O-Si linkages.

Japanese Patent Application No. 4-69901 filed February 12, 1992 by Three-Bond Co., Ltd. discloses an ultraviolet-curing, addition-polymerization-type silicone composition which is curable at room temperature. The disclosed silicone composition comprises a polydiorganosiloxane containing vinyl groups and a polydiorganosilane in which at least 4 silicon atoms are directly bonded in the formula $R_5(Si(R_3)(R_4))_nR_6$ in which $R_3$-$R_6$ are alkyl or aryl, and n is 4 or greater, with the proviso that $R_5$ and $R_6$ may be directly bonded to one another. An addition polymerization catalyst is also included in the composition, such as a platinum catalyst. The composition is uv-light curable with the occurrence of radical addition polymerization.

Hoffman, V., et al., J. Mol. Struct., **293,** 253-256 (1993) describes oligomers including a vinyl group-containing dimethylsiloxane which are thermally as well as photochemically crosslinkable.

Roth, W., et al., Adv. Mater., **2**(10), 497-498 (1990) discloses a methylvinyl-dimethylsiloxane composition that is devoid of photoinitiators, and undergoes radical crosslinking when exposed to laser radiation.

Barrall, E., et al., J. Polym. Sci., Polym. Symp., **71,** 189-202 (1984) describes uv-cured polydimethylsiloxanes containing pendant vinyl groups, wherein the curing involves dicumyl peroxide-mediated vulcanization.

U.S. Patent No. 4,064,027 to Gant describes a uv-curable composition consisting essentially of a vinyl-containing siloxane and siloxane-containing, silicon-bonded hydrogen atoms, in which a mercaptofunctional silicone may be employed as a cure accelerator.

U. S. Patent No. 4,742,092 to Inoue et al. and U. S. Patent No. 4,595,471 to Preiner et al. show UV and dual UV/moisture curable silicones which employ photocurable (meth)acryloxy and isopropenyloxy group containing silicones in combination with mercapto-containing silicones.

EP 0492828 discloses UV curable silicones of alkoxy terminated polydiorganosiloxanes in combination with an alkoxy silicone compound which is capable of photo reactivity. This patent, however, teaches compositions wherein the silanol terminated diorganopolysiloxane is first reacted with solely hydrolyzable groups containing endcappers. As a result, the silicones are not terminated with UV activatable groups.

EP 0539 234 pertains to a composition for a liquid gasket having both an ultraviolet-curing property and a moisture-curing property which is prepared by combining a polysiloxane having at a molecular end at least one group which can be (meth)acryl, a polyorganosiloxane having silanol groups at both molecular ends, an organosilane having at least one hydrolyzable group at a molecular end and a photopolymerization catalyst and a condensation catalyst. The compositions disclosed in this reference are highly viscous, afford a bulk cure and are thus unsuitable for conformal coatings.

Japanese Patent Application No. 92143102 to Tokyo Three Bond Co. Ltd. describes moisture curable and uv-curable compositions of a composition prepared by adding reactive polysiloxane to less equivalent reactive silane compounds having two or three hydrolysable groups, methacryl groups or epoxy groups and reaction of the composition with compounds having at least one vinyl group and methacryl groups and a moisture curing catalyst.

U.S. Patent No. 5,179,134 to Chu et al. describes an acryloxy-functional capped silicone which is formed as a reaction product of a silyl diacrylate compound and a silicone having at least one functionality which is reactive with an acryloxy functionality of the silyl diacrylate compound to yield the acryloxy-functional capped silicone.

Accordingly, it would be a substantial advance in the art, and is correspondingly an object of the present invention, to provide an RTV silicone composition which is rapidly "settable" at the application locus following application of the formulation to such locus, so that migration effects (sag, non-bonding, loss of joint seal integrity, exposure of components intended to be encapsulated, etc.) are minimized or eliminated, but is curable in a conventional manner under ambient atmosphere exposure conditions to moisture cure and achieve superior fully cured properties.

It also would be a substantial advance in the art, and is correspondingly an object of the present invention, to provide a dual uv-curable, moisture curable silicone conformal coating composition wherein uv cure of the composition results in a coating that is dry to the touch without the common tacky surface often associated with an acrylate cure.

Another object of the present invention is to provide an improved RTV silicone composition, which is readily formulated in a convenient manner using conventionally available resin and formulation components.

Yet another object of the present invention is to provide an improved room temperature vulcanizing silicone conformal coating composition of such character, which is readily formulated in a convenient manner using conventionally available formulation components.

Other objects and advantages of the invention will be more fully apparent from the ensuing disclosure and appended claims.

## SUMMARY OF THE INVENTION

The present invention generally relates to radiation- and/or moisture-curable silicone compositions.

In one broad aspect, the invention relates to a radiation and/or moisture-curable room temperature vulcanisable silicone composition, comprising:

(A) a silicone formed as a reaction product of a silanol-terminated silicone and a silane cross-linker; and (B) a photoinitiator effective for radiation curing of the silicone composition;

characterised in that the silicone composition upon exposure to radiation surface cures to form a firm non-tacky surface skin with uncured liquid enclosed underneath the skin; and that the silane cross-linker includes a monovalent ethylenically unsaturated functional group and at least two hydrolyzable functional groups and that the silicone is endcapped with said monovalent ethylenically unsaturated functional group, has a number average molecular weight determined by nuclear magnetic resonance of at least 5000, and wherein the silane cross-linker is devoid of mercapto groups and has the formula:

$$R_aSiX_b$$

wherein:

R is selected from vinyl, propenyl, butenyl, pentenyl, hexenyl, octenyl, allyl, alkenyloxy, alkenylamino, alloyloxy, allylamino, furanyl, phenyl and benzyl groups, and X;

X is a monovalent functionality imparting moisture-curability to the reaction product of the silanol-terminated silicone and silane cross-linker;

a has a value of 1 or 2;

b has a value of 2 or 3; and

$$a + b = 4.$$

A particular aspect of the above-described invention relates to a radiation surface-curable RTV silicone composition which subsequent to radiation surface curing thereof, is interiorly (beneath the radiation-cured surface or "skin" of the composition) moisture-curable in character.

Such RTV silicone composition, of radiation surface-curable, subsequently interiorly moisture-curable, character, may suitably comprise: (i) an ethylenically unsaturated functional group endcapped silicone formed by reacting a silanol-terminated silicone with a non-mercapto-group containing silane cross-linker for the silicone, and a photoinitiator for effecting radiation surface curing of the silicone composition. The cross-linker in such composition has joined directly to a silicon atom thereof an ethylenically unsaturated functional group and at least 2 hydrolyzable groups. The endcapped silicone has a number average molecular weight of at least about 5000, and preferably at least about 10,000, as determined by nuclear magnetic resonance techniques.

The silanol-terminated silicone employed in the RTV silicone composition preferably is predominantly linear in character, with the silanol functionality (-SiOH) located at the terminus of a polysiloxy moiety (-(SiO)$_x$-) in the silicone molecule.

Specific illustrative species of the non-mercapto group containing crosslinker include vinyltrimethoxysilane, vinyltriaminosilane, vinyltriamidosilane, vinyltrioximinosilane, and vinyltriacetoxysilane.

In another aspect, the invention relates to a radiation surface curable silicone material for dispensing to an encapsulation locus including a bounding surface delimiting a potting volume in which an encapsulation structure is disposable for potting in a liquid medium overlaid by an enclosure layer adhesively bonded to the bounding surface wherein the potting material upon exposure to radiation forms a solid skin layer constituting said enclosure layer, overlying uncured liquid of said potting material, and wherein the potting material subsequent to radiation surface curing thereof is surface-curable by irradiation of the material to form said overlying enclosure layer and wherein subsequent to formation thereof the potting material underlying the enclosure layer is moisture curable said potting material comprising the composition as described previously.

In yet another aspect, the present invention relates to a potted element structural article, comprising: structural means defining an encapsulation locus including a bounding surface delimiting an encapsulation volume; a structural element disposed in the encapsulation volume; a potting medium comprising the composition as described above encapsulating the structural element in the encapsulation volume, wherein the potting medium comprises uncured liquid medium overlaid by a solid skin layer enclosingly and adhesively bonded to the bounding surface, so that the element is potted in the silicone composition and the uncured liquid medium is contained in the encapsulation volume by the solid skin layer.

Yet another aspect of the present invention relates to a method of potting an element in a structural encapsulation locus including a bounding wall surface. Such method comprises: disposing said element in the encapsulation locus; dispensing Into the encapsulation locus a silicone potting composition as described hereinabove; and Irradiating the silicone potting composition in the encapsulation locus, to surface-cure same and form a solid silicone layer of the potting material endosingly and adhesively bonded to the bounding surface, and overlying a non-radiation-cured portion of the potting material.

In the above-described potting method, if the vinyl-terminated silicone has no hydrolyzable groups, then the non-radiation-cured potting composition may be uncurable by subsequent moisture exposure. In such instance, the non-radiation-cured potting composition is maintained in an uncured condition, so that the structural element in the encapsulation locus is potted in the non-radiation-cured potting composition, and the non-radiation-cured potting material in turn is overlaid and physically retained in position by the overlying layer of surface-cured potting material.

Alternatively, the non-radiation-cured potting composition may be moisture-curable, and the appertaining potting or manufacturing process may further comprise moisture-curing the non-radiation-cured potting composition subsequent to the irradiating step.

Another compositional aspect of the present invention relates to dual uv radiation and moisture-curable room temperature vulcanizing silicone compositions useful as conformal coating compositions.

The silanol-terminated silicone in such radiation- and moisture-curable silicone composition preferably comprises a linear polydiorganosiloxane having a viscosity as measured on a Brooksfield viscometer at ambient temperature (about 25 °C) not exceeding about 1 Pa·S (1000 cps), preferably not exceeding 0.75 Pa·S (750 cps) and most preferably not exceeding about 0.2 Pa·S (200 cps). In the preferred silanol-terminated silicone of predominantly linear character, the silanol (-SiOH) functionality preferably is located at the terminus of a polysiloxy (-(SiO)$_x$-) moiety in the silicone molecule.

Other aspects and features of the invention will be more fully apparent from the ensuing disclosure and appended claims.

## BRIEF DESCRIPTION OF THE DRAWINGS

    **Figure 1** is a partially sectioned side view of an electronic fuel flow sensor assembly, potted with a silicone composition according to one embodiment of the present invention.

    **Figure 2** is a partially sectioned side view of an electronic fuel flow sensor assembly, potted with a silicone composition according to another embodiment of the present invention.

## DETAILED DESCRIPTION, AND PREFERRED MODES OF CARRYING OUT THE INVENTION

The silicone compositions of the present invention utilize polysilane crosslinkers containing olefinically unsaturated group(s) attached to the silicon atom of the crosslinker.

Such crosslinker by reaction with a silanol-terminated silicone (as shown in equation (1) hereinabove) allows the formulation of RTV silicones for potting, conformal coating, or other applications.

However, the present inventors also unexpectedly discovered that the materials thus prepared, upon formulation with common photoinitiators such as diethoxyacetophenone, can undergo light (actinic radiation exposure) cure to form a firm, non-tacky surface "skin" that possesses structural integrity, i.e., is hard and non-migratory in character, and protects the uncured RTV silicone composition underneath but that does not prevent the moisture cure of the RTV formulation.

Thus, ethylenically-unsaturated silane capping species, such as vinyltrimethoxysilane, vinyltrioximinosilane and vinyltriacetoxysilane, were used to endcap silanol-terminated fluids, to form vinyl-functional products, such as vinyldimethoxy-, vinyldioximinoxy- and vinyldiacetoxy- terminated fluids, respectively. Such fluids upon the addition of photoinitiators were found to undergo surface uv cure to form strong, non-tacky films.

When exposed to suitable actinic radiation of curingly effective character, the resulting radiation-cured surface film is typically sufficiently strong to protect and support the uncured liquid underneath the film even when the substrate element bearing the radiation-cured silicone layer is inverted in relation to its initial radiation exposure position.

When such vinyl-functional products are added to (meth)acryl functionalized silicones, upon the addition of photoinitiators, such fluids undergo uv cure to form strong, non-tacky films when exposed to suitable actinic radiation of curingly effective character. The resulting radiation-cured conformal coating is typically sufficiently strong to provide the requisite protection to the substrate upon which it is coated.

The inventors also discovered that ambient temperature (typically, from about $0°C$ to about $30°C$), atmospheric moisture (normal relative humidity (RH), e.g., from about 2% to 100% RH) exposure conditions can, subsequent to the aforementioned light-induced "skin cure" of the composition, be utilized to effect moisture-curing of the RTV silicone material beneath the radiation-cured skin layer, and surprisingly, the initial surface radiation-cured film formation did not change the hardness of the RTV silicone after such final moisture cure.

In conformal coating applications, the cross-linker/silanol-terminated silicone reaction forms the monovalent ethylenically unsaturated functional group endcapped silicone. The composition comprising the ethylenically unsaturated functional group endcapped silicone and at least one (meth)acryl-functionalized silicone provides a dual uv/moisture curable conformal coating composition having improved surface tack and relatively fast cure time.

In a preferred embodiment, the radiation- and moisture-curable silicone conformal coating composition of the invention comprises a first silicone fluid, a second silicone fluid, and a photoinitiator effective for radiation curing of the silicone composition.

It has been unexpectedly discovered that even though the first and second silicone fluids each have a viscosity which is preferably less than or equal to about 1000 cps and which in and of itself has poor photocuring ability, when present in the silicone conformal coating compositions, upon formulation with common photoinitlators such as diethoxyacetophenone, such silicone fluids can undergo light (actinic radiation exposure) cure in a relatively short period of time to form a firm, non-tacky surface "skin" that possesses structural integrity.

In such coating applications, the silicone compositions of the invention, as a result of their susceptibility to being cured by radiation impingement as well as (or alternatively) by RTV moisture curing, thereby permit great flexibility in use, particularly in instances where the geometric or positional character of the substrate(s) to which the compositions are applied would otherwise cause shading of the silicone composition from the actinic radiation source. In such instances, the applied silicone conformal coating composition of the invention can be moisture cured via RTV crosslinking wherein the slow moisture cure can be allowed to take place under normal atmospheric moisture exposure conditions.

Alternatively, in instances where the applied silicone conformal coating material is not susceptible to shading, phenomena, the material can be fully and solely cured by exposure to actinic radiation. The composition of the present invention is curable at ambient temperature conditions, without any net addition or application of heat to such silicone composition.

Thus, silicone formulations of the present invention can be sequentially polymodally cured, by initial actinic radiation, e.g., uv cure, and subsequent moisture cure, and such silicone formulations are also curable in toto by moisture cure only. In either event (polymodal curing involving sequential initial radiation surface curing followed by bulk interior volume moisture-curing, or unimodal curing involving only moisture curing of the entire silicone formulation), the physical properties of the respective cured materials are substantially the same.

The present invention, as a result of its susceptibility to being surface-cured by radiation impingement as well as (or alternatively) by RTV moisture curing, thereby permits great flexibility in use, particularly in instances where the geometric or positional character of the substrate(s) to which the composition is applied would otherwise cause deleterious sagging or migration of the silicone composition before it is able to be moisture-cured via RTV crosslinking.

In such instances, the applied silicone composition of the invention can be selectively surface cured by radiation exposure, in those regions latently susceptible to sag or migration or alternatively over the entire surface of the applied compositional mass, and then the slow moisture cure can be allowed to take place under normal atmospheric moisture exposure conditions.

Alternatively, in instances where the applied silicone material is not susceptible to sag or migration phenomena, the material can be fully and solely cured by moisture exposure under normal ambient temperature relative humidity conditions. The composition of the present invention is curable at ambient temperature conditions, without any net addition or application of heat to such silicone composition.

The invention can be very useful in many applications.

For example, in potting compound applications, after extruding a silicone potting material according to the present invention into the cavity or interior volume of the structure in which component(s) or other material(s) are to be potted for encapsulation thereof, the applied potting material can be subjected to a quick light irradiation to form a fixed and firm low to non-tacky film of sufficient strength to structurally enclave the uncured RTV silicone composition underneath the surface-curing skin. The resulting potted structural article can then be readily transported, while allowing slow moisture cure to take place during transport and storage of the article.

In this manner, the potting operation can be quickly concluded in the manufacturing facility so that the potted articles are immediately ready for transport and packaging, thereby avoiding the substantial inventory of uncured potted articles which in prior practice has had to be substantially moisture-cured prior to such transport and packaging.

The present invention can be also useful in forming non-tacky coatings which are not inhibited by the presence of oxygen, as is commonly the case with uv cure involving (meth)acrylate functional groups. In silicone compositions according to the invention, in which silicone containing (meth)acryl functionality is present, there may be some inhibition of the (meth)acryl groups, but this phenomenon appears to be masked in such compositions by the presence of monovalent ethylenically unsaturated groups, especially vinyl groups.

As used herein, the term "non-tacky" in reference to the surface of a silicone compositional mass subjected to radiation exposure, means that such surface is deformable, but touch-resilient or non-adherent to, and non-deformed by, the touch, i.e., contact of a human finger with such surface.

The present invention also contemplates the provision of a dual cure silicone composition comprising a uv cure/moisture cure dielectric Igel, in applications where ultraviolet radiation used to effect the uv cure; is not accessible to the entire surface of the applied dielectric gel mass, so that the exterior of the mass includes radiation-accessible (direct impingement) regions as well as shadow regions that are blocked to radiation impingement (e.g., by housing or potted component structures in potting applications; by mask or other material layer elements in conformal coating applications; etc.).

In such "shadow cure" applications of dielectric gels or other silicone compositions of the present invention, both the direct impingement radiation cured/moisture cured regions of the compositional mass, as well as the shadow regions where only moisture-cure took place, would exhibit similar physical properties (e.g., hardness, toughness, thermal resistance, tensile strength, fracture resistance, temperature stability, compressive strength, etc.) in the final cured material.

The silicone conformal coatings of the invention may be cured by exposure to any radiation exposure conditions that are curingly effective for the composition. In like manner, surface-photocurable silicone compositions of the invention may be surface-cured by exposure to any radiation conditions that are surface-curingly-effective for the composition. Suitable radiant energy types that may be usefully employed in the broad practice of the invention include electron beam radiation, ultraviolet radiation, visible light radiation, gamma radiation, X-rays, β-rays, etc. Preferably, the photocuring radiation is actinic radiation, i.e., electromagnetic radiation having a wavelength of about 700 nm or less that is capable of effecting the requisite cure, e.g., surface cure of the silicone composition in the case of potting or other extended depth silicone formulation volumes, or full volume cure (in the case, for example, of thin conformal coatings) of the silicone composition. Most preferably, the photocuring radiation comprises ultraviolet (uv) radiation having a wavelength of for example from about 200 to about 540 nm.

It will be recognized that the type and character of the photocuring radiation, e.g., surface-curing radiation that is used to form a cured skin or film on the silicone compositional mass of the present invention after its application to the substrate or other locus of use, or the full body curing radiation for curing an extended depth mass of the silicone composition, may be widely varied within the broad scope of the present invention, and that the radiation exposure cure times in any given application are correspondingly variable, with respect to and depending on such factors as: the particular silicone formulation employed, type and light-responsiveness of the specific photoinitiator employed, the wavelength and flux of the radiation, the concentration of the photoinitiator in the composition, and the thickness of the coating or other form of the applied compositional mass.

Generally, the radiation exposure time is relatively short, that is, less than about 3 minutes. Exposing the composition to excessive amounts of radiation may "overcure" the composition, resulting in poor physical and performance properties. The amount of radiation that is excessive varies with the given formulation of the silicone composition, coating thickness, radiation source, etc., and may readily be determined by the skilled artisan without undue experimentation.

Correspondingly, the thickness of the radiation-cured skin that is efficacious to provide the required structural stability and containment of the underlying uncured (e.g., liquid or flowable (semi)solid) silicone composition in a surface-cure system, or to provide the required structural stability and protection of the substrate in a full cure system, are readily determinable within the skill of the art by routine and simple experimentation. Generally, conformal coatings are on the order of less than about 15 mils thick, typically from about 76.2 (3) to about 254 μm (10 mils) in thickness.

For example, the depth of cure required in a given end use application may be empirically established by exposure of corresponding amounts of the composition on separate substrate samples to varying amounts of radiation (or other varying parameters, e.g., amounts in the respective compositional samples of photoinitiator; or amounts of filler; or distances between the applied compositional mass and the radiation source; etc.), followed by translation, inversion, etc. of the samples to determine which composition samples sag or migrate, e.g., in the case of potting or high-depth bulk masses of the silicone formulation.

In the case of conformal coatings, such step of motive determination of sag or migration susceptibility can be replaced by a corresponding step of touching the samples to determine which composition samples are tacky to the touch.

The silanol-terminated silicone utilized in the potting or bulk deposited silicone compositions of the present invention may suitably comprise a linear polydiorganosiloxane, or other linear silicone, having a weight average molecular weight which may for example range from about 1,000 to about 300,000, preferably from about 10,000 to about 80,000, and most preferably from about 10,000 to about 50,000.

The silanol-terminated silicone which preferably is utilized to form the ethylenically unsaturated functional group endcapped silicone in the conformal coating compositions of the present invention may suitably comprise a linear polydiorganosiloxane, or other linear silicone, having a weight average molecular weight which may for example range from about 166 to about 20,000 preferably from about 500 to about 12,000, and most preferably from about 800 to about 8000. Such silanol-terminated silicone has a viscosity at ambient (about 25 °C) of less than or equal to about 1 Pa·S (1000 cps), preferably less than or equal to about 0.75 Pa·S (750 cps), and most preferably of less than or equal to about 0.2 Pa·S (200 cps).

Although such silicone is preferably linear in conformation, other, non-linear silicones, e.g., branched, cyclic or macromeric, may be usefully employed in the broad practice of the present invention. Preferably, the silicone (polysiloxane) is predominantly linear in character. The silanol (-SiOH) functionality is located at the terminus of a polysiloxy $(-(SiO)_x-)$ moiety in the silicone molecule, e.g., the hydroxy functionality is covalently bonded to a terminal silicon atom of the polysiloxy backbone, in the case of a linear silicone, or to a terminal silicon atom of a main or side chain or other aggregation of siloxy repeating units in the case of a branched or otherwise nonlinear silicone molecular conformation.

Preferably, the polysiloxane is a linear molecule both of whose terminal functional groups comprise hydroxy groups. Thus, for example, the polysiloxane material may comprise a hydroxy-terminated polydimethylsiloxane, or a hydroxy-terminated polydiphenylsiloxane. Preferably, the silicone is an organopolysiloxane whose organo substituents are predominantly methyl.

A particularly preferred polysiloxane material which has been usefully employed in the potting or bulk deposited silicone compositions of the present invention is a hydroxy-terminated polydimethylsiloxane of linear configuration, having a weight average molecular weight as determined by gel-permeation chromatography technique on the order of 10,000 to 50,000.

A particularly preferred polysiloxane material which has been usefully employed in conformal coating compositions according to the present invention is a hydroxy-terminated polydimethylsiloxane of linear configuration, having a weight average molecular weight as determined by nuclear magnetic resonance technique on the order of 4,000.

The non-mercapto-group-containing silane cross-linker employed in the compositions of the invention for cross-linking of the silanol-terminated silicone, as well as the silane cross-linker employed in compositions of the invention for endcapping of the silanol-terminated silicone to obtain the monovalent ethylenically unsaturated functional group endcapped silanol, suitably comprises a silane compound having joined directly to a silicon atom thereof an ethylenically unsaturated functional group and at least two hydrolyzable functional groups.

By way of example, in the case of potting or bulk deposited compositions of the present invention utilizing silane cross-linker species such as vinyltrimethoxysilane, vinyltriaminosilane, vinyltriamidosilane, vinyltrioximinosilane, and vinyltriacetoxysilane, the cross-linker concentration is generally on the order of from about 1% to 10% by weight, based on the weight of the silanol-terminated silicone, and more preferably from about 1.5% to 5% by weight, on the same silanol-terminated silicone weight basis.

In conformal coating applications utilizing the above silane cross-linker species, or species such as vinyltriisopropenyloxysilane, the cross-linker concentration is generally on the order of from about 1% to 50% by weight, based on the weight of the silanol-terminated silicone.

In contrast to the silicone compositions disclosed in Bennington U.S. Patent 4,526,955, which describes the use of an organosilicon compound having an average of at least two and preferably three or four groups per molecule having Si-N and/or Si-O-N linkages, the crosslinker silanes utilized in the present invention comprise compounds having an ethylenically unsaturated functional group directly bonded to a silicon ,atom of the silane and at least two hydrolyzable functional groups joined directly to a silicon atom of the silane, with such silane, and the resulting silicone (polysiloxane) product formed by reaction of the crosslinker and the silanol-functionalized silicone, having Si-C and/or Si-O-C bonded moieties.

In conformal coating applications of the invention, as well as in other applications, the composition may further comprise a nonreactive moiety endcapped silicone in order to modify the viscosity of the silicone fluid. Suitable nonreactive moiety encapped silicones for use in the present invention include, but are not limited to, alkyl, aryl, arylalkyl, and alkylaryl endcapped silicone. An example of a specific nonreactive moiety endcapped silicone suitable for use in the invention is trimethylsilyl endcapped polydimethylsiloxane.

In the compositions of the invention having utility for conformal coating compositions, the at least one (meth) acryl-functionalized silicone has a functional group which is selected from the group consisting of acryl, (meth)acryl, propenyl, butenyl, pentenyl, hexenyl, octenyl, allyl, alkenyloxy, alkenylamino, allyloxy, allylamino, furanyl, phenyl, and benzyl groups, and at least one hydrolyzable group which is selected from the same hydrolyzable groups on the monovalent ethylenically unsaturated functional group endcapped silicone.

Preferred functionalized silicones are the (meth)acryloxy or acryloxy alkyl or (meth)acryloxy or acryloxy alkenyl functionalized silicones. Suitable (meth)acryl-functionalized silicones for use in the present invention include, but are not limited to, methacryloxypropyldimethoxysilyl terminated silicone, acryloxypropyldimethoxysily terminated silicone or a mixture thereof. (Meth)acryl-functionalized silicones are known and can be prepared in accordance with any known method including those exemplified in U.S. Patent Nos. 4,503,208; 4,504,629; 4,575,545; 4,575.546; 4,760,122; 4,290,869 and 4,595,471, the entire disclosures of which are all hereby incorporated herein by reference.

The photoinitiator employed in silicone compositions of the present invention may suitably comprise a photoinitiator that may include any photoinitiator known in the art that is useful to effect photopolymerization of ethylenically unsaturated (e.g., vinyl or allyl) compounds in the presence of curingly effective radiation.

Potentially useful photoinitiators may include, by way of example, benzoin, substituted benzoins such as benzoin ethyl ether, benzophenone, benzophenone derivatives, Michler's ketone, dialkoxyacetophenones such diethoxyacetophenone, acetophenone, benzil, and other derivatives (substituted forms) and mixtures thereof.

A particularly preferred photoinitiator material is diethoxyacetophenone. Although any suitable effective amount of photoinitiator may be employed in the surface photocurable silicone compositions of the invention, generally the photoinitiator concentration will be usefully employed in the range of about 0.1% to about 10% by weight, and more specifically and preferably from about 0.2% to about 5% by weight, based on the weight of the hydroxy-functional silicone.

The photoinitiator employed in the photocurable silicone compositions of the present invention may also be polymer bound. Such photoinitiators are described in U.S. Patent Nos. 4,477,326 and 4,587,276. Other free radical initiators, such as peroxy thermal initiators may be used in some of the lower molecular weight silicone formulations of the invention.

Suitable moisture cure initiators for use in various silicone compositions of the present invention include any such initiators known in the art including orthotitanate.

The compositions of the present invention may also include other ingredients to modify the cured or uncured properties of the composition, as necessary or desirable for a specific end use application.

In instances where the non-mercapto group containing silane cross-linker species used in the present invention is vinyltrimethoxysilane, a curing catalyst may be necessary. Examples of curing catalysts include, but are not limited to, tin, titanium, aluminum, zirconium and any other suitable curing catalyst known in the art.

Fillers or reinforcing materials may usefully be employed in compositions of the present invention to provide enhanced mechanical properties, and in some instances enhanced UV radiation surface curability of the composition.

Among preferred fillers are reinforcing silicas. The reinforcing silicas are fumed silicas which may be untreated (hydrophilic) or treated to render them hydrophobic in character.

In general, fillers may be employed at any suitable concentration in the curable silicone composition, but generally are present at concentrations of from about 5 to about 45% by weight, based on the weight of the polysiloxane. Generally, any other suitable mineralic, carbonaceous, glass or ceramic fillers may be potentially advantageously be employed. Examples include ground quartz, tabular alumina, diatomaceous earth, silica balloons, calcium carbonate, carbon black, titanium oxide, aluminum oxide, aluminum hydroxide, zinc oxide, glass fibers, etc.

In addition, the silicone compositions of the present invention may also optionally contain an adhesion promotor, to enhance the adhesive character of the composition for a specific substrate (e.g., metal, glass, ceramic, etc.), when the composition is employed as an adhesive for bonding of respective substrate elements or members.

Any suitable adhesion promotor constituents may be employed for such purpose, depending on the specific substrate elements or members employed in a given application. For example, the adhesion promotor might be selected to enhance the adhesion of the composition on substrates comprising materials such as metals, glasses, ceramics, plastics, and mixtures, blends, composites, and combinations thereof.

Various organosilane compounds may be usefully employed for such purpose, and such compounds may also feature oxirane functionality, as well as silicon-bonded alkoxy substituents, to provide broad adhesive bonding utility. In such organosilane compounds, the oxirane functionality may be provided by a glycidoxyalkyl substituent on a silicon atom of the silane compound. A particularly preferred adhesion promotor of such type is glycidoxypropyltrimethoxysilane.

In addition, further additives such as MQ or MDQ resins can be incorporated, to vary the properties of the silicone composition as desired.

Besides the constituents identified above as being optionally includable in the silicone compositions of the present invention, further optional constituents include anti-oxidants, flame retardants, and pigments, etc., as well as filler adjuvants, e.g., filler-treating agents such as hydroxy-terminated vinylmethoxysiloxane, for filler treatment of quartz or similar fillers when used in the composition.

In respect of filler components of the silicone compositions of the present invention, it will be appreciated that the use of filler materials may significantly alter the depth of the surface cure of the compositional mass, and fillers may therefore be usefully employed to attain a predetermined desired cured skin thickness on the exterior surface of the compositional mass.

Radiation exposure surface curing of the silicone compositions of the present invention may suitably be carried out in an ambient atmosphere or in an inert atmosphere such as nitrogen or argon atmosphere. Moisture curing of moisture-curable compositions of the present invention is typically suitably carried out in ambient atmospheric exposure conditions, but such curing may alternatively be conducted in an elevated humidity cabinet or other synthetic high humidity environment for the requisite moisture curing period, which may be readily determined within the skill of the art in relation to determination of the product final moisture-cured properties.

The silicone compositions of the present invention utilize components that are easily synthesized within the skill of the art, and/or are readily commercially available.

In making the silicone compositions of the present invention, the silanol-terminated silicone component and the non-mercapto group containing silane cross-linker may be reacted with one another at ambient temperature, e.g., at room temperature in the range of 20°C - 30°C, for sufficient time to complete the reaction, typically 0.5 to 4 hours. Alternatively, elevated temperature may be employed to speed the rate of reaction, however, ambient temperature conditions are generally satisfactory and preferred for ease of synthesis.

The reaction mixture may optionally, if desired, include a suitable catalyst, such as an organometallic compound (e.g., butyllithium) to facilitate the reaction between the silanol-terminated silicone reactant and the silane crosslinker. After the desired extent of reaction, such catalyst may be quenched, for example by addition of acid in the case of organometallic reagents.

After the reaction between the silanol-terminated silicone reactant and the silane crosslinker has been carried out, the silicone fluid reaction product is simply admixed with the photoinitiator for subsequent exposure of the resulting composition to photopolymerizingly effective radiation to (surface, or bulk) cure the composition.

The silicone fluid reaction product may thus be admixed with the photoinitiator under non-radiation-exposure conditions, and the resulting mixed composition may be stored in containers which are non-transmissive of photopolymerizingly effective radiation, as a single package composition for subsequent use.

Alternatively, the silicone fluid reaction product may be utilized as a two-part or two-package system, in which the silicone fluid reaction product is admixed with the photoinitiator component at the time of use, immediately before application thereof to the locus of use, and curingly effective irradiation of the applied mixed composition.

The at least partially radiation-curable silicone compositions of the present invention may be variously formulated for suitable use in any variety of applications, including usage as sealants, adhesives, potting compounds, shock or impact damping media, conformal coatings, etc.

In some applications of the present invention, as more fully described hereinafter with reference to Example 7 hereof, it may be desirable to formulate the radiation surface-curable silicone composition so that the radiation surface-cured film of the composition will be transmissive of moisture, but the ethylenically unsaturated functional group endcapped silicone has no hydrolyzable groups so that moisture curing of the underlying non-radiation-cured composition does not take place.

Such compositions may for example be utilized for coating, potting, or other applications, in which it is desired to provide a solid cured silicone film (layer) overlying uncured silicone liquid.

In potting applications, for example, such compositional mass, comprising a surface radiation-cured skin capable of retaining the underlying liquid in the potting locus by adhesive bonding of the solid cured silicone skin layer to the bounding surface(s) of the potting locus, can protect the potted element, e.g., an electromechanical mechanism, in the underlying liquid.

The underlying liquid thus subsequently functions as a fluid damping medium which may in fact be superior to solid potting materials in securing the potted element against damage or displacement which might otherwise occur in instances where the potted element assembly is; subject to impact, shock, vibration, etc.

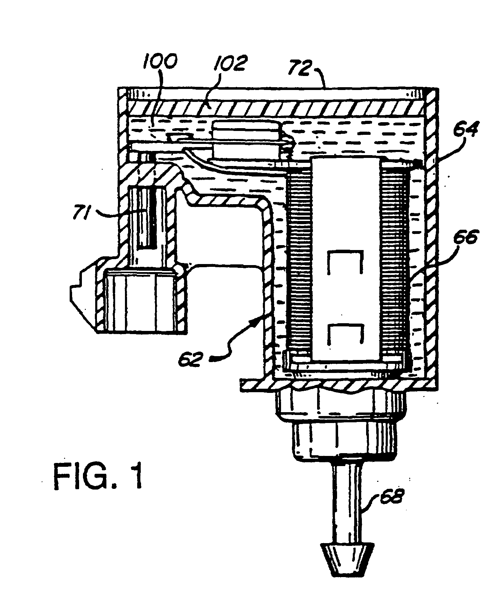

**Figure 1** is a partially sectioned side view of an electronic fuel flow sensor assembly, potted with a silicone composition according to one embodiment of the present invention.

The sensor assembly **62** comprises a housing **64** in which is disposed a solenoidal element **66.** The solenoidal element is joined by suitable electronic coupling means to female connector elements **71** which permit the sensor assembly to be installed in an automotive electronic system for monitoring fuel flow. The sensor assembly comprises intake port **68** and outlet port **70** providing for fuel flow through the device.

In the housing of the sensor assembly there is an interior space **72** surrounding the solenoidal element **66** and its associated electronic coupling means, to which the potting composition of the invention may be introduced and sequentially cured as previously described. The potting mass comprises an upper radiation-cured skin **102** which is a cured silicone solid layer or film, and which at its periphery is adherently joined (bonded) to the side walls of the housing **64**.

By such arrangement, the radiation-cured skin **102** overlies, and encloses (together with the side walls of the housing), the uncured liquid silicone composition **100**. If the skin **102** is moisture-permeable in character, but the liquid silicone is not moisture curable as described more fully hereinafter in connection with Example 7 hereof, then the silicone liquid **100** is permanently maintained in liquid state, and constitutes a liquid potting medium for the solenoidal element **66** and associated element structure.

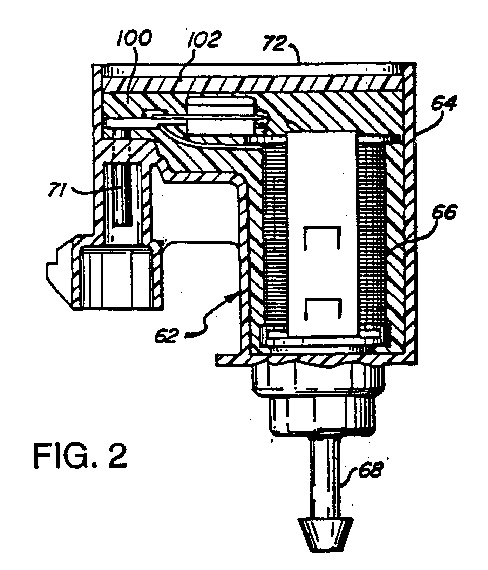

**Figure 2** is a partially sectioned side view of a corresponding electronic fuel flow sensor assembly, potted with a silicone composition according to another embodiment of the present invention. The corresponding parts and elements are numbered in **Figure 2** with the same reference numerals used in **Figure 1**. In the **Figure 2** embodiment, the potting composition comprises the radiation-surface-cured skin layer **102** overlying the moisture-cured silicone mass **100** surrounding and encapsulating the solenoidal element **66** and associated element structure. In this Figure 2 embodiment, the upper layer **100** subsequent to radiation surface-curing formation thereof, remains moisture permeable, so that moisture transmission through the upper skin layer **102** has resulted in moisture-cure of the underlying potting material **100** to a solid state.

In the **Figures 1** and **2** embodiments, the thickness of the skin layer **102** may be on the order of 254 (10) to 1524 µm (60 mils), depending on the type and character of radiation utilized to effect the cure-formation thereof.

The radiation- and moisture-curable silicone compositions of the present invention thus afford a quick and convenient means for potting an element, in which the initial radiation exposure forms a solid skin layer permitting subsequent moisture-curing of the underlying silicone composition, but which at the same time permits immediate handling, transport and storage of the skin-cured potted article. If such immediate handleability is not required, the entire mass of the composition may be fully moisture-cured, without the expedient of radiation exposure to form the upper skin layer.

The features and advantages of the invention are more fully illustrated in the following non-limiting examples, wherein all parts and percentages are by weight, unless otherwise expressly stated.

## EXAMPLE 1

Five hundred ninety-four grams of a silanol-terminated polydimethylsiloxane fluid with an average molecular weight of 18,000 (gel-permeation chromatography) was reacted with 10 g of vinyltrimethoxysilane using a butylithium catalyst for 2 hours. The catalyst was then quenched with acid. The material thus obtained is a vinyldimethoxy-terminated silicone fluid.

To 20 g of the above fluid was added 0.30 g of diethoxyacetophenone and 0.10 g of titanium tetraisopropoxide and the resulting composition (denoted hereinafter as "Base Composition") was thoroughly mixed.

The Base Composition mixture was separated into 2 equal fractions and poured into aluminum dishes. One of these fractions, denoted here as Sample A, was subjected to uv irradiation using a Fusion System ultraviolet light source with a light intensity of ~75 milliwatts per square centimeter (mw/cm$^2$) for one minute. The irradiated material formed a firm non-tacky surface skin having a pale yellowish tint, and with uncured liquid enclosed underneath the skin.

Attempted determination of the hardness of the material using a Durometer (00) gauge failed to register a reading (hardness 0). However, the skin film was firm enough so that the needle of the durometer gauge will not penetrate (rupture) the film. Inversion of the aluminum dish did not cause the liquid enclosed by the film to leak through it or rupture the film.

The other of the fractions, denoted here as Sample B, was not surface radiation-cured or otherwise exposed to curingly effective radiation.

Both of the samples then were moisture-cured overnight and Durometer (00) readings were taken the following day for each. The Durometer (00) value measured for Sample A was 70 and the Durometer (00) value measured for Sample **B** was **67**.

As a comparison, the Base Composition was modified with only 1.5% diethoxyacetophenone being added and without any titanium tetraisopropoxide therein (hereinafter denoted "Modified Composition A"). Modified Composition A was uv-curable (using the same irradiation system as described above) to yield a firm layer of non-tacky skin with liquid enclosed therein. The enclosed liquid, however, would not moisture cure. Inversion of the aluminum dish did not cause the liquid to leak through the skin.

As a further comparison, a mixture of 594 g of the above silanol terminated fluid and 10 g of the vinyltrimethoxysilane was made. Twenty grams of this mixture was formulated with 0.30 g of diethoxyacetophenone. The formulated mixture (hereinafter denoted "Modified Composition B") was subjected to the same uv irradiation system as above described and only a very thin layer of tacky skin was obtained. Inversion of the aluminum dish caused the liquid underneath the skin to leak through the thin skin. The skin was also readily removed by finger touch.

As still a further comparison, 370.4 g of the same silanol fluid was reacted with 5.6 g methyltrimethoxysilane using butylithium catalyst for **2** hours. The catalyst was then quenched by acid. The material thus obtained was a methyldimethoxy terminated silicone fluid. To 20 g of this fluid was further added 0.30 g of diethoxyacetophenone. The resulting mixture (hereinafter denoted "Modified Composition C") was subjected to the same uv irradiation system as described above.

Only a very thin surface layer of film was formed. Inverting the container of the mixture after uv curing caused the enclosed liquid to flow through the thin film immediately. The film itself was so weak that lightly touching the film caused the film to be lifted from the liquid.

**EXAMPLE 2**

Twenty grams of the silanol terminated fluid with an average molecular weight of 18,000 was mixed with 0.72 g of vinyltrioximinosilane [CH2=CHSi(ON=CMeEt)$_3$]. The mixture was further formulated with 0.30 g of diethoxyacetophenone and 0.10 g of dimethyl tin bis(neodecanoate).

The mixture was separated into two equal fractions, denoted hereinafter as "Sample C" and "Sample D," respectively . Sample C was subjected to uv cure as described in Example 1 whereas Sample D was moisture cured. The uv cured Sample C was an initial pale yellowish gel with a firm, non-tacky surface probably with fluid underlying the gel. The film was firm enough so that when the aluminum dish was inverted, no enclosed liquid leaked through the film.

The hardness of the surface-cured Sample C material was found to be Durometer (00) of zero. Both Sample C and Sample D were exposed to atmospheric relative humidity conditions to complete the moisture cure. Both Sample C and Sample D showed Durometer (00) readings of 62 after final moisture cure.

As a comparison, vinyltrioximinosilane was replaced by methyltrioximinosilane in the above-described formulation procedure and the resulting composition (Sample E) when irradiated by the same uv curing procedure as Sample C yielded a material with a very thin tacky skin which was readily lifted away upon lightly touching the surface with fingers. When the dish was attempted to be inverted, the uncured liquid beneath the skin immediatedly flowed through the film.

**EXAMPLE 3**

Twenty grams of the silanol terminated fluid with an average molecular weight of 18,000 was mixed with 0.72 g of vinyltrioximinosilane. To this mixture was further and sequentially added 0.80 g ethyltriacetoxysilane, 0.30 g diethoxyacetophenone, and 0.10 g dimethyl tin bis(neodecanoate).

The formulation was separated into two equal fractions, denoted hereinafter as Sample F and Sample G, respectively. Sample F was subjected to uv curing by the same irradiation procedure as described above for Sample C. The mixture formed a firm, non-tacky skin film layer upon uv cure. No liquid leaked through the film when the aluminum dish containing the surface-cured material was inverted. Both Sample F and Sample G then were moisture-cured for **72** hours, following which Durometer (00) values were determined. Each of the Samples F and G yielded Durometer (00) readings of **60**.

As a comparison, the order of addition of vinyltrioximinosilane and ethyltriacetoxysilane was reversed in the above process, and the resulting material (Sample H) upon uv cure (by the same irradiation procedure as Sample C) formed a very thin tacky film which was readily lifted by the touch of a finger. Inverting the aluminum dish containing this surface-cured material caused an immediate flow of the liquid through the film. This formulation then was moisture-cured for **72** hours, yielding a cured silicone material having a Durometer (00) hardness value of **60**.

**EXAMPLE 4**

Vinyltriacetoxysilane (0.47 g) was added to 20.74 g of silanol terminated silicone fluid with an average molecular weight of 20,000. To this mixture was further added 0.30 g of diethoxyacetophenone and 0.10 g dimethyl tin bis(neodecanoate). The formulation was thoroughly mixed and deaerated.

The resulting mixture then was separated into two equal fractions, denoted hereinafter as Sample I and Sample J.

Sample I was uv cured by the same irradiation procedure as described above for Sample C to yield a surface-cured silicone material having a firm non-tacky skin which was strong enough to hold the uncured liquid beneath the skin when the aluminum dish was inverted.

Both Sample I and Sample J then were moisture-cured overnight to form a cured silicone rubber product. Both cured materials (Sample I and Sample J) had the same Durometer (00) hardness value of **73**.

## EXAMPLE 5

Silanol-terminated polydimethylsiloxane fluids with an average molecular weight of 20,000 were partially endcapped with trimethylchlorosilane and hexamethyldisilazane. The resulting fluids were filtered and further endcapped with vinyltrioximinosilane.

The fluids upon addition of 1.5% diethoxyacetophenone and 0.5% dimethyl tin bis(neodecanoate) were found to be uv-surface-curable (by the same irradiation method described for Sample C) to yield an irradiated silicone material having a non-tacky skin. These formulations were also determined to be moisture-curable to form silicone rubbers.

The hardness of the fully cured product rubbers was found to be correlated to the levels of trimethylsilyl endgroups. Specifically, the higher the trimethylsilyl level in the formulation, the softer the cured product rubber. The hardness of the cured product rubber samples was found to be unrelated to the mode of cure. Thus, both (uv/moisture) dual cure silicone rubber products and moisture-only cure silicone rubber products exhibited similar hardness levels as shown in Table I below.

TABLE I

| HARDNESS VALUES FOR SAMPLES SEQUENTIALLY CURED BY INITIAL UV EXPOSURE FOLLOWED BY MOISTURE CURE (DUAL CURE), VERSUS SAMPLES FULLY CURED ONLY BY MOISTURE CURE (MONOCURE) | | | | | |
|---|---|---|---|---|---|
| Curing Modality | 0%$Me_3$Si-100% VISI (Oxime)$_3$ | 25%$Me_3$Si-75%VISI (Oxime)$_3$ | 40%$Me_3$Si-60%VISI (Oxime)$_3$ | 50%$Me_3$Si-50%VISI (Oxime)$_3$ | 60%$Me_3$Si-40%VISI (Oxime)$_3$ |
| Dual Cure | 71 | 69 | 43 | 22 | gum |
| Monocure | 72 | 69 | 41 | 23 | gum |

## EXAMPLE 6

The silicone composition formulation procedure of Example 5 was repeated using the following photoinitiators in place of diethoxyacetophenone:

Darocur 1116 (($CH_3$)$_2$H$C_6$$H_4$C=OC($CH_3$)$_2$OH),
1173 (2-hydroxy-2-methyl-1-phenyl-propane-1-one),
1664 (proprietary, E.M. Industries), and
2273 (proprietary, E.M. Industries).

In all cases the irradiation of the applied compositions on the substrate (aluminum pan) by the irradiation procedure of Example 1 yielded radiation-surface-cured materials having firm non-tacky surface layer films with characteristics similar to those obtained using the photoinitiators of Example 5.

## EXAMPLE 7

A vinyl-terminated silicone polymer having a weight average molecular weight of 93,000 was formulated with 1.5% diethoxyacetophenone. The resulting silicone material upon uv irradiation formed a gel with liquid underneath the surface skin layer. This material however would not moisture cure.

This composition illustrates an embodiment of the invention that may be useful in instances where formation of a strong and physically continuous film on top of a fluid is desired to prevent the underlying (uncured) fluid from migrating.

The silicone composition of this Example may thus be usefully employed as a potting material, in which the silicone composition is dispensed into a housing containing a mechanism, structural element, or other material(s) for encapsulation thereof. Subsequent to dispensing, the composition is irradiated with surface-curingly-effective radiation to form a firm, fixedly positioned and stable skin layer on the upper surface of the potting mass. Below such overlying cured silicone layer, contained by the bounding surfaces of the housing, is the uncured liquid silicone composition.

The underlying liquid, as a result of its confinement by the surface-cured skin and bounding cavity surfaces to which the skin is adherently bonded, thereafter functions as a fluidic encapsulation and shock damping system.

As a result of its viscous damping character, the uncured potting material contained by the overlying cured layer of potting material is markedly superior to solid (fully cured resin) potting compositions of the prior art, in respect of protecting the encapsulated structure or material from damage or displacement which otherwise may occur due to shocks, vibration, impact, etc. exerted on the encapsulation (potting) system.

Further, the "liquid potting" formulation of the invention is not subject to differential thermal expansion effects which adversely affect solid potting masses by causing cracking and stress fractures and associated tensile, compressive, and torsional forces on the mechanisms or elements being encapsulated by the potting medium.

For these reasons, the liquid potting structure of the present invention, comprising a surface radiation-cured skin and an underlying uncured liquid, in a cavity or other containment locus, is a marked advance in the art of potting and encapsulation.

## EXAMPLE 8

Forty grams of 0.1 Pa·S (100 cps) (Brooksfield viscometer) silanol-terminated polydimethylsiloxane fluid with a number average molecular weight of 5,000 (nuclear magnetic resonance) was mixed (encapped) with 5.00 g of vinyltris(methylethylketoximino)silane. The initially cloudy mixture became clear in a matter of seconds when endcapping was complete. To the mixture was further added 0.675 g of diethoxyacetophenone.

To an aluminum dish with a diameter of 65 mm was added 0.5 g of the above formulation. The material was allowed to spread to cover the whole dish. The thickness of the coating coverage was approximately 6 mils. UV irradiation of the coating using a Fusion System lamp (medium pressure mercury lamp) at a radiation flux of @ 75 milliwatts/cm$^2$ for one minute resulted in a soft cured silicone coating that was dry to the touch. The coating will further moisture cure to give a hard silicone coating.

In contrast, when methyltris(methylethylketoximino)-silane was used in place of vinyltris(methylethyl-ketoximino)silane in the above formulation, the resulting material showed no uv curing capability under identical curing conditions. The material remained liquid after attempted uv curing. The material did moisture cure to a silicone coating after a few hours standing.

## EXAMPLE 9

Six hundred grams of a 0.4 Pa·S (40 cps) (Brooksfield viscometer) silicone fluid, 80% of which had silanol terminal ends and 20% of which had trimethylsilyl ends was mixed with two hundred fifty-seven grams of methacryloxypropyltrimethoxysilane in a reactor with nitrogen sparge. Butyllithium catalyst (1.6M; 0.36 g) was added to the mixture. The mixture was stirred with- nitrogen sparge for 90 minutes and then sparged with carbon dioxide for 30 minutes. The mixture was then vacuum stripped at 70 degrees Centigrade for 1 hour to obtain a silicone fluid which was 80% methacryloxypropyldimethoxy terminated and 20% trimethylsily terminated and designated as Fluid M.

## EXAMPLE 10

Two hundred forty one grams of the 0.4 Pa·S (40 cps) silicone fluid with 80% silanol terminated ends and 20% trimethylsilyl ends was allowed to react with ninety grams of acryloxypropyltrimethoxysilane in the presence of 0.5 ml of butyllithium (1.6M) in accordance with the procedure set forth in Example 9 to obtain an 80% acryloxypropyldimethoxysilyl terminated, 20% trimethylsily terminated silicone fluid designated as Fluid A.

## EXAMPLE 11

Two hundred fifty seven grams of the 0.4 Pa·S (40 cps) silicone fluid with 80% silanol terminated ends and 20% trimethylsilyl ends was allowed to react with 61.7 grams of vinyltrimethoxysilane in the presence of 0.2 ml of butyllithium (1.6M) in accordance with the procedure set forth in Example 9 to obtain. an 80% vinyldimethoxysilyl terminated, 20% trimethylsily terminated silicone fluid designated as Fluid V.

**EXAMPLE 12**

Two hundred sixty grams of the 0.4 Pa·S (40 cps) silicone fluid with 80% silanol terminated ends and 20% trimethylsilyl ends was allowed to react with 35 grams of methacryloxypropyltrimethoxysilane, 33 grams of acryloxypropyltrimethoxysilane and 21 grams of vinyltrimethoxysilane in the presence of 0.3 ml of butyllithium (1.6M) in accordance with the procedure set forth in Example 9 to obtain a silicone fluid of approximately 27% methacryloxypropyldimethoxysilyl ends, 26% acryloxypropyldimethoxysilyl ends, 27 % vinyldimethoxysilyl ends and 20 trimethylsilyl ends, designated as Fluid MAV.

Example 12 embodies an alternative method for the preparation of the compositions of the present invention wherein the first and second silicone fluids are prepared concurrently from an appropriate silanol or silanol mixture and first silane having a monovalent, radiation curable ethylenically unsaturated group and at least two hydrolyzable groups and at least one other silane having a (meth)acryl functional groups and at least two hydrotyzable groups.

It is recognized that one silicone fluid may have both a radiation curable ethylenically unsaturated group and a radiation curable (meth)acryl functional group. However, because of the mole ratio of these moieties, at least some of the silicone fluids having the (meth)acryl functional groups will be free of the ethylenically unsaturated group. The mole ratio of silanes is dependent upon the level of monovalent, radiation curable ethylenically unsaturated groups desired with the total amount of silanes being about the stoichiometric amount relative to the SiOH functionality of the starting silanol fluid.

**EXAMPLE 13**

Seven sample formulations (Samples 1-7) were prepared wherein the silicone fluids, obtained from the procedures set forth in Examples 9-12, were included in varying ratios as set forth for each sample in Table II below. Diethoxyacetophenone in the amount of 6.5% based on weight of total silicones, was added to each sample as the photoinitiator. Approximately 0.5 grams of each sample formulation was poured into an aluminum dish of approxiamtely 65 mm diameter. The material was spread to coat the whole base of the dish to an approximate thickness of 5 mil. The coating was subjected to uv irradiation using a Fusion System ultraviolet light source with a light intensity of ~60 milliwatts per square centimeter (mw/cm$^2$) for various durations as set forth in Table II.

Tackiness of the resulting uv cured coatings were determined by lightly touching the coating with a finger. A number of 0-5 was then assigned to each coating. The number grade denotes the tackiness of the surface cure and is defined as below:

0 =   no cure
1 =   some thickening of the coating fluid, surface remains liquid covered.
2 =   significant thickening of the fluid, when touched upon, the fluid momentarily maintained a fingerprint mark,
3 =   coating cured to a gum, leaves a fingerprint mark when touched,
4 =   coating is cured but tacky,
5 =   coating is fully cured with a dry to the touch surface.

The 7 sample formulations used and their tackiness performances at different levels of curing are shown in Table II below:

TABLE II

| SAMPLE | 1 | 2 | 3 | 4 | 5 | 6 | 7 |
|---|---|---|---|---|---|---|---|
| Fluid M | 93.5% | 73.5% | 73.5% | 73.586 | 0% | 0% | 0% |
| Fluid V | 0% | 20% | 0% | 0% | 93.5% | 0% | 0% |
| Fluid A | 0% | 0% | 20% | 0% | 0% | 93.5% | 0% |
| Fluid MAV | 0% | 0% | 0% | 20% | 0% | 0% | 93.5% |
| DEAP | 6.5% | 6.5% | 6.5% | 6.5% | 6.5% | 6.5% | 6.5% |
| *UV 60 sec* | 5 | 5 | 5 | 5 | 0 | 5 | 5 |
| *30 sec* | 2 | 3 | 1 | 1 | 0 | 2 | 4 |
| *25 sec* | 1 | 2 | 2 | 2 | 0 | 1 | 4 |
| *20 sec* | 1 | 2 | 1 | 1 | 0 | 1 | 3 |

TABLE II   (continued)

| SAMPLE | 1 | 2 | 3 | 4 | 5 | 6 | 7 |
|---|---|---|---|---|---|---|---|
| 15 sec | 1 | 2 | 1 | 0 | 0 | 0 | 3 |
| 10 sec | 0 | 1 | 0 | 0 | 0 | 0 | 2 |

The results set forth in Table II indicate that presence of Fluid V resulted in a much improved surface cure than of Fluid M by itself (Sample 1) or Fluid A by itself (Sample 6). Fluid V by itself (Sample 5), however, performed poorly. The best performance was with Fluid MAV (Sample 7).

## EXAMPLE 14

Seven additional sample formulations (Samples 8-14) were prepared wherein the silicone fluids obtained from the procedures set forth in Examples 9-12 were included in varying ratios as set forth for each sample in Table III below. Diethoxyacetophenone in the amount of 6.5% based on weight of total silicones, was added to each sample as the photoinitiator and tetraisopropyl titanate was added as a moisture cure initiator. Each sample formulation coating was subjected to uv cure according to the procedure set forth for samples 1-7 in Example 13 above. The samples were further allowed to moisture cure to non-tacky coatings. Surface tack immediately after the uv cure, but before the moisture cure were determined as set forth in Example 13. The formulations for samples 8-14 and the performances are set forth in Table III below.

TABLE III

| SAMPLE | 8 | 9 | 10 | 11 | 12 | 13 | 14 |
|---|---|---|---|---|---|---|---|
| Fluid M | 93.1% | 73.1% | 73.1% | 73.1% | 0% | 0% | 0% |
| Fluid V | 0% | 20% | 0% | 0% | 93.1% | 0% | 0% |
| Fluid A | 0% | 0% | 20% | 0% | 0% | 93.1% | 0% |
| Fluid MAV | 0% | 0% | 0% | 20% | 0% | 0% | 93.1% |
| DEAP | 6.5% | 6.5% | 6.5% | 6.5% | 6.5% | 6.5% | 6.5% |
| TIPT | 0.4% | 0.4% | 0.4% | 0.4% | 0.4% | 0.4% | 0.4% |
| UV 60 sec | 5 | 5 | 5 | 5 | 0 | 5 | 5 |
| 30 sec | 5 | 5 | 5 | 5 | 0 | 5 | 5 |
| 25 sec | 2 | 3 | 4 | 4 | 0 | 4 | 4 |
| 20 sec | 1 | 2 | 2 | 2 | 0 | 2 | 3 |
| 15 sec | 0 | 2 | 2 | 2 | 0 | 2 | 3 |
| 10 sec | 0 | 1 | 1 | 1 | 0 | 1 | 2 |

The results set forth in Table III indicate that partial replacement of Fluid M by Fluid V resulted in a much improved surface cure than of Fluid M by itself even though Fluid V itself would not surface cure (Sample 12). Overall results were such that presence of vinyl provided a faster to the touch cure. It is believed that the presence of moisture cure catalyst combined with heat of the photocure enhanced surface cure of acrylate and methacrylate compositions. Even though acrylate composition appears to perform nearly as well as vinyl containing compounds, the vinyl resins do not have environmental, health and safety concerns associated with acryl functional silicone.

## INDUSTRIAL APPLICABILITY OF THE INVENTION

The radiation- and/or moisture-curable silicone compositions of the present invention have utility as sealants, adhesives, coatings, potting compositions, and the like.

In such applications, the radiation curability of the silicone composition permits the ready dispensing and curing of the silicone material and corresponding ready handling and further processing of structural surfaces, parts, and assemblies with which the silicone composition is employed.

Further, the liquid potting application described hereinabove may be employed in the potting of mechanical and/or electrical assemblies, in a manner using the uncured potting material as a viscous damping medium. Such potting arrangement minimizes the susceptibility of the potted structural element to damage or malfunction from shock, translation and impact of the potted assembly.

While the invention has been illustratively described herein with reference to various preferred features, aspects and embodiments, it will be appreciated that the invention is not thus limited, and may be widely varied in respect of alternative variations, modifications, and other embodiments, and therefore the invention is to be broadly construed as including such alternative variations, modifications and other embodiments, within the spirit and scope of the invention as claimed.

## Claims

1. A radiation and/or moisture-curable room temperature vulcanisable silicone composition comprising:

   (A) a silicone formed as a reaction product of a silanol-terminated silicone and a silane cross-linker; and

   (B) a photoinitiator effective for radiation curing of the silicone composition;

   **characterised in that** the silicone composition upon exposure to radiation surface cures to form a firm non-tacky surface skin with uncured liquid enclosed underneath the skin; and **that** the silane cross-linker includes a monovalent ethylenically unsaturated functional group and at least two hydrolyzable functional groups; and **that** the silicone is endcapped with said monovalent ethylenically unsaturated functional group, has a number average molecular weight determined by nuclear magnetic resonance of at least 5000, and wherein the silane cross-linker is devoid of mercapto groups and has the formula:

$$R_aSiX_b$$

   wherein:

   R is selected from vinyl, propenyl, butenyl, pentenyl, hexenyl, octenyl, allyl, alkenyloxy, alkenylamino, allyloxy, allylamino, furanyl, phenyl and benzyl groups, and X;

   wherein:

   X is a monovalent functionality imparting moisture-curability to the reaction product of the silanol-terminated silicone and silane cross-linker;
   a has a value of 1 or 2;
   b has a value of 2 or 3; and

$$a + b = 4$$

2. A composition as claimed in claim 1, wherein the silanol-terminated silicone is a linear polydiorganosiloxane having a weight average molecular weight of from 5,000 to 300,000 as determined by gel-permeation chromatography.

3. A composition according to claim 1 or 2, wherein the endcapped silicone has a number average molecular weight of at least 10,000.

4. A composition as claimed in any of claims 1 to 3, wherein the silanol-terminated silicone is predominantly linear in character, having the silanol (-SiOH) functionality located at the terminus of a polysiloxy ($-(SiO)_x-$) moiety in the silicone molecule.

5. A composition as claimed in any of claims 1 to 4, wherein the silanol-terminated silicone is a linear molecule both of whose terminal functional groups comprise hydroxy groups.

6. A composition as claimed in any of claims 1 to 5, wherein the silanol-terminated silicone is an organopolysiloxane whose organo substituents are predominantly methyl.

7. A composition as claimed in any of claims 1 to 6, wherein the monovalent ethylenically unsaturated group contains from 2 to 12 carbon atoms.

8. A composition as claimed in any of claims 1 to 7, wherein R is a vinyl group or an allyl group.

9. A composition as claimed in any of claims 1 to 8, wherein the silane cross-linker is selected from the group vinyltrimethoxysilane, vinyltriaminosilane, vinyltriamidosilane, vinyltrioximinosilane, vinyltriisopropenoxysilane, and vinyltriacetoxysilane.

10. A composition as claimed in any of claims 1 to 9, wherein the photoinitiator is selected from the group benzoin, benzophenone, Michler's ketone, dialkoxyacetophenones, acetophenone, benzil, and derivatives and mixtures thereof.

11. A composition as claimed in any of claims 1 to 10, wherein the photoinitiator is diethoxyacetophenone.

12. A composition as claimed in any of claims 1 to 11, wherein the photoinitiator has a concentration of from 0.1% to 10% by weight, based on the weight of the silanol-terminated silicone.

13. A radiation surface curable silicone potting material for dispensing to an encapsulation locus including a bounding surface delimiting a volume in which an encapsulation structure is disposable for potting in a liquid medium overlaid by an enclosure layer adhesively bonded to the bounding surface, wherein the potting material upon exposure to radiation forms a solid skin layer constituting said enclosure layer, overlying uncured liquid of said potting material, and wherein the potting material subsequent to radiation surface curing thereof is surface-curable by irradiation of the material to form said overlying enclosure layer and wherein subsequent to formation thereof the potting material underlying the enclosure layer is moisture curable, said potting material comprising the composition of claim 1.

14. A potted element structural article, comprising:

   means defining an encapsulation locus including a bounding surface delimiting an encapsulation volume;

   an element disposed in the encapsulation volume; and

   a potting medium comprising the composition of claim 1 encapsulating the element in the encapsulation volume, said potting medium comprising the uncured liquid medium overlaid by said solid skin layer enclosingly and adhesively bonded to the bounding surface, so that the element is potted in the silicone composition, and the uncured liquid medium is contained in the encapsulation volume by said solid skin layer.

15. A potted element structural article as claimed in claim 14, wherein the means defining an encapsulation locus comprise a housing including bounding side walls providing said bounding wall surface.

16. A potted element structural article as claimed in claims 14 or 15, wherein the potted element comprises at least one member selected from electrical, mechanical, electronic, optical, acoustic, and material elements.

17. Apotted element structural article as claimed in any of claims 14 to 16, wherein the potted element is an electromechanical element.

18. A method of potting an element in a structural encapsulation locus including a bounding wall surface, said method comprising:

   disposing said element in the encapsulation locus;

   dispensing into the encapsulation locus a radiation surface-curable silicone potting composition comprising the composition of claim 1; and

   irradiating the silicone potting composition in the encapsulation locus, to surface-cure same and form a solid silicone layer enclosingly and adhesively bonded to the bounding surface, and overlying non-radiation-cured potting composition.

**Patentansprüche**

1. Strahlungs- und/oder feuchtigkeitshärtbare raumtemperaturvulkanisierbare Siliconzusammensetzung, umfassend:

   (A) ein Silicon, das als Reaktionsprodukt eines silanolterminierten Silicons und eines Silan-Vernetzungsmittels gebildet wurde, und
   (B) einen Photoinitiator, der die Strahlungshärtung der Silicon-Zusammensetzung bewirkt,

   **dadurch gekennzeichnet, daß** die Siliconzusammensetzung bei der Einwirkung von Strahlung an der Oberfläche härtet, um eine feste nichtklebrige Oberflächenhaut zu bilden, wobei unter der Haut ungehärtete Flüssigkeit eingeschlossen ist, und **daß** das Silan-Vernetzungsmittel eine monovalente ethylenisch ungesättigte funktionelle Gruppe und wenigstens zwei hydrolysierbare funktionelle Gruppen umfaßt, und **daß** das Silicon mit der genannten monovalenten ethylenisch ungesättigten funktionellen Gruppe endverkappt ist, ein durch kernmagnetische Resonanz ermitteltes Zahlenmittel-Molekulargewicht von wenigstens 5000 hat und wobei das Silan-Vernetzungsmittel frei von Mercaptogruppen ist und die Formel:

$$R_aSiX_b$$

   hat, wobei:

   R ausgewählt ist aus Vinyl-, Propenyl-, Butenyl-, Pentenyl-, Hexenyl-, Octenyl-, Allyl-, Alkenyloxy-, Alkenylamino-, Allyloxy-, Allylamino-, Furanyl-, Phenyl- und Benzylgruppen und X,

   wobei:

   X eine monovalente Funktionalität ist, die dem Reaktionsprodukt aus dem silanolterminierten Silicon und dem Silan-Vernetzungsmittel Feuchtigkeitshärtbarkeit verleiht,
   a einen Wert von 1 oder 2 hat,
   b einen Wert von 2 oder 3 hat und

$$a + b = 4.$$

2. Zusammensetzung gemäß Anspruch 1, wobei das silanolterminierte Silicon ein lineares Polydiorganosiloxan mit einem durch Gelpermeationschromatographie ermittelten massegemittelten Molekulargewicht von 5000 bis 300000 ist.

3. Zusammensetzung gemäß Anspruch 1 oder 2, wobei das endverkappte Silicon ein Zahlenmittel-Molekulargewicht von wenigstens 10000 besitzt.

4. Zusammensetzung gemäß irgendeinem der Ansprüche 1 bis 3, wobei das silanolterminierte Silicon überwiegend linearen Charakter besitzt und die Silanol(-SiOH)-Funktionalität sich am Ende eines Polysiloxy(-(SiO)$_x$-)-Restes in dem Siliconmolekül befindet.

5. Zusammensetzung gemäß irgendeinem der Ansprüche 1 bis 4, wobei das silanolterminierte Silicon ein lineares Molekül ist, dessen beide endständige funktionelle Gruppen Hydroxygruppen umfassen.

6. Zusammensetzung gemäß irgendeinem der Ansprüche 1 bis 5, wobei das silanolterminierte Silicon ein Organopolysiloxan ist, dessen Organosubstituenten überwiegend Methyl sind.

7. Zusammensetzung gemäß irgendeinem der Ansprüche 1 bis 6, wobei die monovalente ethylenisch ungesättigte Gruppe 2 bis 12 Kohlenstoffatome enthält.

8. Zusammensetzung gemäß irgendeinem der Ansprüche 1 bis 7, wobei R eine Vinylgruppe oder eine Allylgruppe ist.

9. Zusammensetzung gemäß irgendeinem der Ansprüche 1 bis 8, wobei das Silan-Vernetzungsmittel ausgewählt ist aus der Gruppe aus Vinyltrimethoxysilan, Vinyltriaminosilan, Vinyltriamidosilan, Vinyltrioximinosilan, Vinyltriisopropenoxysilan und Vinyltriacetoxysilan.

10. Zusammensetzung gemäß irgendeinem der Ansprüche 1 bis 9, wobei der Photoinitiator ausgewählt ist aus der Gruppe aus Benzoin, Benzophenon, Michlers Keton, Dialkoxyacetophenonen, Acetophenon, Benzil und Derivaten und Mischungen davon.

11. Zusammensetzung gemäß irgendeinem der Ansprüche 1 bis 10, wobei der Photoinitiator Diethoxyacetophenon ist.

12. Zusammensetzung gemäß irgendeinem der Ansprüche 1 bis 11, wobei der Photoinitiator eine Konzentration von 0,1 Gew.-% bis 10 Gew.-% hat, bezogen auf das Gewicht des silanolterminierten Silicons.

13. An der Oberfläche strahlungshärtbares Silicon-Einbettmaterial zum Verteilen an einem Einkapselungsort, umfassend eine Grenzfläche, die ein Volumen abgrenzt, in das eine Einkapselungsstruktur zum Einbetten in einem flüssigen Medium eingebracht werden kann, überlagert von einer umschließenden Schicht, die klebend mit der Grenzfläche verbunden ist, wobei das Einbettmaterial bei der Einwirkung von Strahlung eine feste Hautschicht bildet, die die genannte umschließende Schicht darstellt und über der ungehärteten Einbettmaterial-Flüssigkeit liegt, und wobei das Einbettmaterial im Anschluß an dessen Oberflächen-Strahlungshärtung durch Bestrahlung des Materials oberflächenhärtbar ist, um die genannte überlagerte umschließende Schicht zu bilden, und wobei im Anschluß an deren Bildung das Einbettmaterial, das unter der umschließenden Schicht liegt, feuchtigkeitshärtbar ist, wobei das Einbettmaterial die Zusammensetzung nach Anspruch 1 umfaßt.

14. Strukturgegenstand mit eingebettetem Element, umfassend:

Mittel, die einen Einkapselungsort definieren, einschließlich einer Grenzfläche, die ein Einkapselungsvolumen abgrenzt,
ein Element, das sich in dem Einkapselungsvolumen befindet, und
eine Einbettmasse, welche die Zusammensetzung nach Anspruch 1 umfaßt und das Element in dem Einkapselungsvolumen einkapselt, wobei die genannte Einbettmasse die ungehärtete flüssige Masse umfaßt, überlagert von der genannten festen Hautschicht, die umschließend und klebend mit der Grenzfläche verbunden ist, so daß das Element in der Siliconzusammensetzung eingebettet ist, und die ungehärtete flüssige Masse durch die genannte feste Hautschicht in dem Einkapselungsvolumen gehalten wird.

15. Strukturgegenstand mit eingebettetem Element gemäß Anspruch 14, wobei die Mittel, die einen Einkapselungsort definieren, ein Gehäuse mit seitlichen Begrenzungswänden umfassen, welche die Oberfläche der genannten Grenzfläche zur Verfügung stellen.

16. Strukturgegenstand mit eingebettetem Element gemäß den Ansprüchen 14 oder 15, wobei das eingebettete Element wenigstens ein Element umfaßt, ausgewählt aus elektrischen, mechanischen, elektronischen, optischen, akkustischen und Materialelementen.

17. Strukturgegenstand mit eingebettetem Element gemäß irgendeinem der Ansprüche 14 bis 16, wobei das eingebettete Element ein elektromechanisches Element ist.

18. Verfahren zum Einbetten eines Elements in einem Struktur-Einkapselungsort mit einer Grenzwandfläche, wobei das Verfahren umfaßt:

Einbringen des genannten Elements in den Einkapselungsort,
Verteilen einer an der Oberfläche strahlungshärtbaren Silicon-Einbettzusammensetzung, die die Zusammensetzung nach Anspruch 1 umfaßt, an dem Einkapselungsort und
Bestrahlen der Silicon-Einbettzusammensetzung an dem Einkapselungsort, um diese an der Oberfläche zu härten und eine feste Siliconschicht zu bilden, die umschließend und klebend mit der Grenzfläche verbunden ist und über der nicht-strahlungsgehärteten Einbettzusammensetzung liegt.

**Revendications**

1. Une composition de silicone vulcanisable à la température ambiante durcissable par irradiation et/ou par l'humidité, comprenant :

(A) une silicone formée comme produit réactionnel d'une silicone à terminaison silanol et d'un agent de réticulation du type silane ; et
(B) un photo-initiateur efficace pour le durcissement par irradiation de la composition de silicone ;

**caractérisée en ce que** la composition de silicone, après exposition à un rayonnement, durcit en surface pour former une peau superficielle ferme non collante avec du liquide non durci enfermé sous la peau ; et **en ce que** l'agent de réticulation du type silane comprend un groupe fonctionnel monovalent éthyléniquement insaturé et au moins deux groupes fonctionnels hydrolysables ; et **en ce que** la silicone est coiffée par ledit groupe fonctionnel monovalent éthyléniquement insaturé, a un poids moléculaire moyen en nombre, déterminé par résonance magnétique nucléaire, d'au moins 5000, et dans laquelle l'agent de réticulation du type silane est dépourvu de groupes mercapto et répond à la formule :

$$R_aSiX_b$$

où :

R est choisi parmi les groupes vinyle, propényle, butényle, pentényle, hexényle, octényle, allyle, alcényloxy, alcénylamino, allyloxy, allylamino, furannyle, phényle et benzyle, et X ;
Où X est une fonctionnalité monovalente conférant une aptitude au durcissement par l'humidité au produit réactionnel de la silicone à terminaison silanol et de l'agent de réticulation du type silane ;
la valeur de a est 1 ou 2 ;
la valeur de b est 2 ou 3 ; et

$$a + b = 4.$$

2. Une composition telle que revendiquée dans la revendication 1, dans laquelle la silicone à terminaison silanol est un polydiorganosiloxane linéaire ayant un poids moléculaire moyen en poids de 5000 à 300 000 tel que déterminé par chromatographie par perméation de gel.

3. Une composition selon la revendication 1 ou 2, dans laquelle la silicone coiffée a un poids moléculaire moyen en nombre d'au moins 10 000.

4. Une composition telle que revendiquée dans l'une quelconque des revendications 1 à 3, dans laquelle la silicone à terminaison silanol est de caractère principalement linéaire, ayant la fonctionnalité silanol (-SiOH) située à l'extrémité d'un fragment polysiloxy (-(SiO)$_x$-) dans la molécule de silicone.

5. Une composition telle que revendiquée dans l'une quelconque des revendications 1 à 4, dans laquelle la silicone à terminaison silanol est une molécule linéaire dont les deux groupes fonctionnels terminaux comprennent des groupes hydroxyle.

6. Une composition telle que revendiquée dans l'une quelconque des revendications 1 à 5, dans laquelle la silicone à terminaison silanol est un organopolysilane dont les substituants organiques sont principalement des groupes méthyle.

7. Une composition telle que revendiquée dans l'une quelconque des revendications 1 à 6, dans laquelle le groupe monovalent éthyléniquement insaturé contient 2 à 12 atomes de carbone.

8. Une composition telle que revendiquée dans l'une quelconque des revendications 1 à 7, dans laquelle R est un groupe vinyle ou un groupe allyle.

9. Une composition telle que revendiquée dans l'une quelconque des revendications 1 à 8, dans laquelle l'agent de réticulation du type silane est choisi parmi le vinyltriméthoxysilane, le vinyltriaminosilane, le vinyltriamidosilane, le vinyltrioximinosilane, le vinyltriisopropénoxysilane et le vinyltriacétoxysilane.

**10.** Une composition telle que revendiquée dans l'une quelconque des revendications 1 à 9, dans laquelle le photo-initiateur est choisi dans la classe formée par la benzoïne, la benzophénone, la cétone de Michler, les dialcoxyacétophénones, l'acétophénone, le benzile, et leurs dérivés et mélanges.

**11.** Une composition telle que revendiquée dans l'une quelconque des revendications 1 à 10, dans laquelle le photo-initiateur est la diéthoxyacétophénone.

**12.** Une composition telle que revendiquée dans l'une quelconque des revendications 1 à 11, dans laquelle la concentration du photo-initiateur est de 0,1 % à 10 % en poids, par rapport au poids de la silicone à terminaison silanol.

**13.** Une matière de silicone d'enrobage à surface durcissable par irradiation, destinée à être délivrée à un site d'encapsulation comprenant une surface limite délimitant un volume dans lequel une structure d'encapsulation peut être placée pour l'enrobage dans un milieu liquide recouvert par une couche d'enfermement liée par adhésion à la surface limite, dans laquelle la matière d'enrobage, après exposition à un rayonnement, forme une couche de peau solide constituant ladite couche d'enfermement, recouvrant un liquide non durci de ladite matière d'enrobage, et dans laquelle la matière d'enrobage, après avoir été durcie en surface par irradiation, est durcissable en surface par irradiation de la matière pour former ladite couche d'enfermement recouvrante, et dans laquelle, après sa formation, la matière d'enrobage se trouvant sous la couche d'enfermement est durcissable par l'humidité, ladite matière d'enrobage comprenant la composition de la revendication 1.

**14.** Un article structural à élément enrobé, comprenant :

des moyens définissant un site d'encapsulation comprenant une surface limite délimitant un volume d'encapsulation ;
un élément disposé dans le volume d'encapsulation ; et
un milieu d'enrobage comprenant la composition de la revendication 1, encapsulant l'élément dans le volume d'encapsulation, ledit milieu d'enrobage comprenant le milieu liquide non durci recouvert par ladite couche de peau solide liée à la surface limite par adhésion et d'une manière réalisant un enfermement, de sorte que l'élément est enrobé dans la composition de silicone, et le milieu liquide non durci est contenu dans le volume d'encapsulation par ladite couche de peau solide.

**15.** Un article structural à élément enrobé tel que revendiqué dans la revendication 14, dans lequel le moyen définissant le site d'encapsulation comprend un boîtier comprenant des parois latérales limites formant ladite surface de paroi limite.

**16.** Un article structural à élément enrobé tel que revendiqué dans les revendications 14 ou 15, dans lequel l'élément enrobé comprend au moins un membre choisi parmi les éléments électriques, mécaniques, électroniques, optiques, acoustiques et matériels.

**17.** Un article structural à élément enrobé tel que revendiqué dans l'une quelconque des revendications 14 à 16, dans lequel l'élément enrobé est un élément électromécanique.

**18.** Un procédé d'enrobage d'un élément dans un site structural d'encapsulation comprenant une surface de paroi limite, ledit procédé consistant à :

placer ledit élément dans le site d'encapsulation ;
distribuer dans le site d'encapsulation une composition de silicone d'enrobage à surface durcissable par irradiation, comprenant la composition de la revendication 1 ; et
irradier la composition de silicone d'enrobage dans le site d'encapsulation pour la durcir en surface et former une couche de silicone solide liée à la surface limite par adhésion et d'une manière réalisant un enfermement, et recouvrant la composition d'enrobage non durcie par irradiation.

FIG. 1

FIG. 2